(19) Europäisches Patentamt

European Patent Office

Office européen des brevets

(11) **EP 1 074 092 B1**

(12) **FASCICULE DE BREVET EUROPEEN**

(45) Date de publication et mention
de la délivrance du brevet:
**18.12.2002 Bulletin 2002/51**

(51) Int Cl.⁷: **H04B 1/04**, H04L 27/36,
H03F 1/16

(21) Numéro de dépôt: **99914600.4**

(22) Date de dépôt: **16.04.1999**

(86) Numéro de dépôt international:
**PCT/FR99/00901**

(87) Numéro de publication internationale:
**WO 99/056400 (04.11.1999 Gazette 1999/44)**

(54) **PROCEDE DE NEUTRODYNAGE DU TUBE D'UN EMETTEUR**

NEUTRALISIERUNGSVERFAHREN FÜR EINE SENDERRÖHRE

METHOD FOR NEUTRALISING A TRANSMITTER TUBE

(84) Etats contractants désignés:
**CH DE FR GB LI**

(30) Priorité: **24.04.1998 FR 9805180**

(43) Date de publication de la demande:
**07.02.2001 Bulletin 2001/06**

(73) Titulaire: **Thales
75008 Paris (FR)**

(72) Inventeur: **LAURENT, Pierre André,
Thales Intellectual Propert
F-94117 Arcueil Cedex (FR)**

(74) Mandataire: **Chaverneff, Vladimir et al
THALES Intellectual Property
13, Avenue du Président Salvador Allende
94117 Arcueil Cédex (FR)**

(56) Documents cités:
**EP-A- 0 658 975       EP-A- 0 907 276
FR-A- 2 652 470**

## Description

La présente invention concerne un procédé de neutrodynage du tube d'un émetteur de radiodiffusion de type numérique de forte puissance et un émetteur de radiodiffusion mettant en oeuvre ce procédé.

Les émetteurs de radiodiffusion actuellement utilisés en ondes courtes sont optimisés pour avoir un très haut rendement lors de l'émission en modulation d'amplitude pure avec résidu de porteuse.

Cette optimisation est obtenue notamment en utilisant un tube d'émission de forte puissance agissant essentiellement comme un commutateur commandé au rythme de l'onde porteuse à transmettre. Le tube d'émission agit sur un signal de haute tension qui est fourni par un modulateur dont la structure est adaptée à la modulation utilisée (modulations IML, abréviation de « impulsion modulée en largeur », PSM abréviation de l'expression anglo-saxonne « pulse state modulation » par exemple) et qui est proportionnelle à l'amplitude instantanée du signal HF. Les nouveaux systèmes de radiodiffusion en cours de normalisation sont de type numérique de sorte que la forme de l'onde qu'ils émettent n'a pas de rapport immédiat avec celle du signal audiofréquence.

L'utilisation, dans ces systèmes de radiodiffusion, des mêmes tubes qu'auparavant associés à un ou plusieurs modulateurs tout en voulant émettre une telle forme d'onde nécessite, d'une part, que la porteuse de référence soit modulée en phase et, d'autre part, que le neutrodynage du tube soit très bien réalisé. Compte tenu des contraintes géométriques imposées généralement à la réalisation de l'étage final des amplificateurs, le neutrodynage effectué suivant les méthodes actuelles, qui reposent sur des circuits de compensation analogique, ne peut pas être totalement efficace.

Le but de l'invention est de proposer un procédé adapté à un système de radiodiffusion de type numérique pour remédier à l'inconvénient précité.

A cet effet, l'invention a pour objet un procédé de neutrodynage du tube d'un émetteur de radiodiffusion de type numérique de forte puissance comprenant un amplificateur travaillant à saturation avec un gain $V_1$ et amplifiant un signal d'entrée modulé en phase issu d'un modulateur modulant à une fréquence d'émission deux signaux en quadrature pour commander la grille du tube, celui-ci travaillant à saturation avec un gain $V_2$, caractérisé en ce qu'il consiste à pré-distordre par des moyens numériques le signal d'entrée pour compenser le couplage indésirable entre l'anode et la grille du tube de l'émetteur de telle sorte que la sortie de l'émetteur corresponde à un signal de sortie désiré.

L'invention a également pour objet un émetteur de radiodiffusion mettant en oeuvre le procédé précité.

L'invention a pour avantage de réaliser d'une manière numérique la compensation des interférences entre l'anode et la grille. Cette caractéristique permet de s'affranchir de contraintes géométriques qui accompagnent généralement la conception de l'étage final d'amplification. Le caractère numérique permet aussi une compensation totalement adaptée, souple et évolutive qui ne nécessite pas de modification lourde de l'émetteur.

Suivant un mode préférentiel de mise en oeuvre du procédé, la détermination de la fonction de transfert H(t) du couplage anode-grille est réalisée à des instants réguliers. Ce mode permet d'obtenir un neutrbdynage qui prend en compte des phénomènes de dérive (dus par exemple au vieillissement, à la chaleur) qui se manifestent en particulier par des rotations de phase.

D'autres caractéristiques et avantages de l'invention apparaîtront dans la description qui suit faite en regard des dessins annexés qui représentent :

- la figure 1A, une modélisation d'un émetteur élémentaire,
- la figure 1B, une représentation dans le plan complexe de signaux mis en jeu dans l'émetteur élémentaire de la figure 1A,
- la figure 2A, une modélisation d'un émetteur mettant en oeuvre le procédé selon l'invention,
- la figure 2B, une représentation dans le plan complexe de signaux mis en jeu dans l'émetteur de la figure 2A,
- la figure 3, un émetteur mettant en oeuvre le procédé selon l'invention équipé d'un système de calibration.

Une modélisation d'un émetteur élémentaire est représentée sur la figure 1A. L'émetteur comprend un synthétiseur 1, un modulateur 2, un étage amplificateur 3 dit « driver » et un tube de sortie 4. La représentation fait apparaître le couplage 5 existant entre l'anode et la grille du tube.

Le synthétiseur 1 génère un signal sinusoïdal dit « de référence » à une fréquence d'émission $F_0$ appelée aussi fréquence porteuse.

Le modulateur 2 a deux voies en quadrature, l'une correspondant au signal d'entrée I(t) et l'autre au signal d'entrée Q(t). Il génère un signal de sortie E(t) qui est une modulation à la fréquence $F_0$ du signal de référence généré par le synthétiseur 1. Il s'exprime sous la forme :

$$E(t) = I(t) \cos 2\pi F_0(t) + Q(t)\sin 2\pi F_0(t) \qquad (1)$$

Le signal modulé E(t) est amplifié par l'étage amplificateur 3, de quelques kW de puissance, qui est modélisé sous la forme d'un limitateur dur suivi d'un multiplieur de gain fixe $V_1$. Le terme limitateur dur désigne un dispositif qui ne modifie pas la phase du signal d'entrée et qui délivre un signal de sortie avec une amplitude constante.

Le signal amplifié X(t) conserve par conséquent la phase $\varphi$ du signal modulé E(t) mais présente une amplitude $V_1$ en prenant l'amplitude du signal modulé E(t) comme référence.

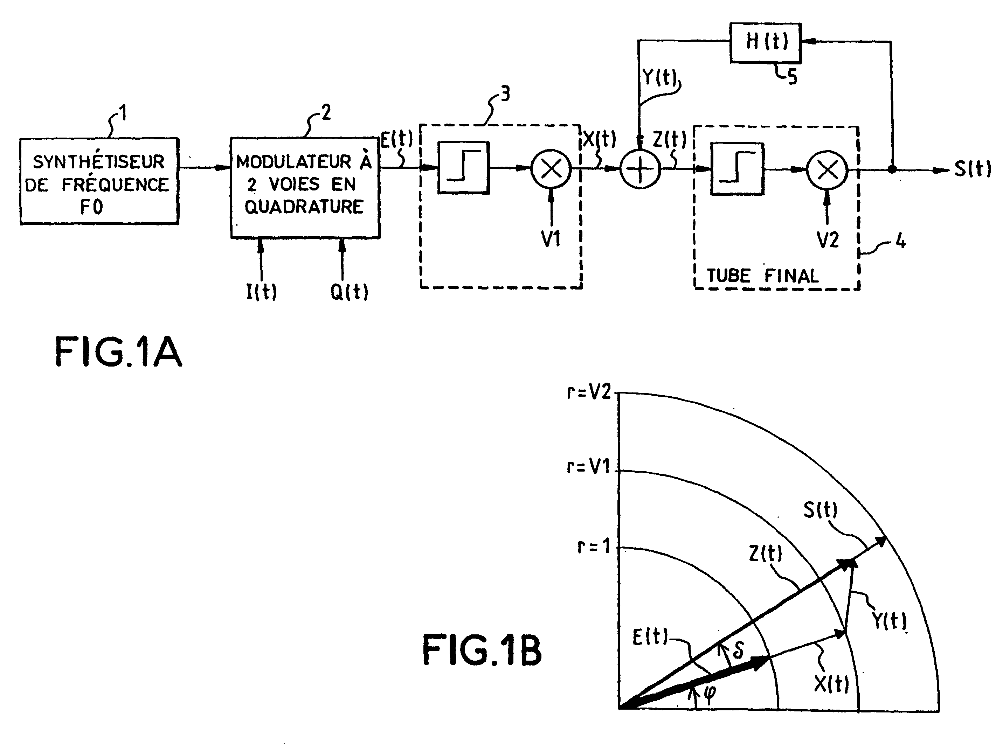

La figure 1B donne une représentation schématique dans le plan complexe des signaux mis en jeu en considérant leur amplitude relative ainsi que leur phase relative. Le signal E(t) est représenté avec une amplitude de 1; le signal X(t) a donc une amplitude $V_1$. La grille du tube de sortie 4, considérée comme l'entrée du tube, voit le signal amplifié X(t) auquel vient s'additionner une fraction Y(t) du signal de sortie S(t) pris sur l'anode du tube. La fraction Y(t) est due au couplage 5 entre l'anode et la grille du tube qui est induit par la capacité parasite existant entre la grille et l'anode. En notant H(t) la fonction de transfert du couplage 5 entre l'anode et la grille, la fraction Y(t) est le résultat de la convolution du signal de sortie S(t) et de la fonction de transfert H(t). Soit l'expression suivante :

$$Y(t) = S(t) * H(t) \qquad (2)$$

Le résultat de l'addition correspond au signal Z(t) que « voit » l'entrée du tube :

$$Z(t) = X(t) + S(t) * H(t) \qquad (3)$$

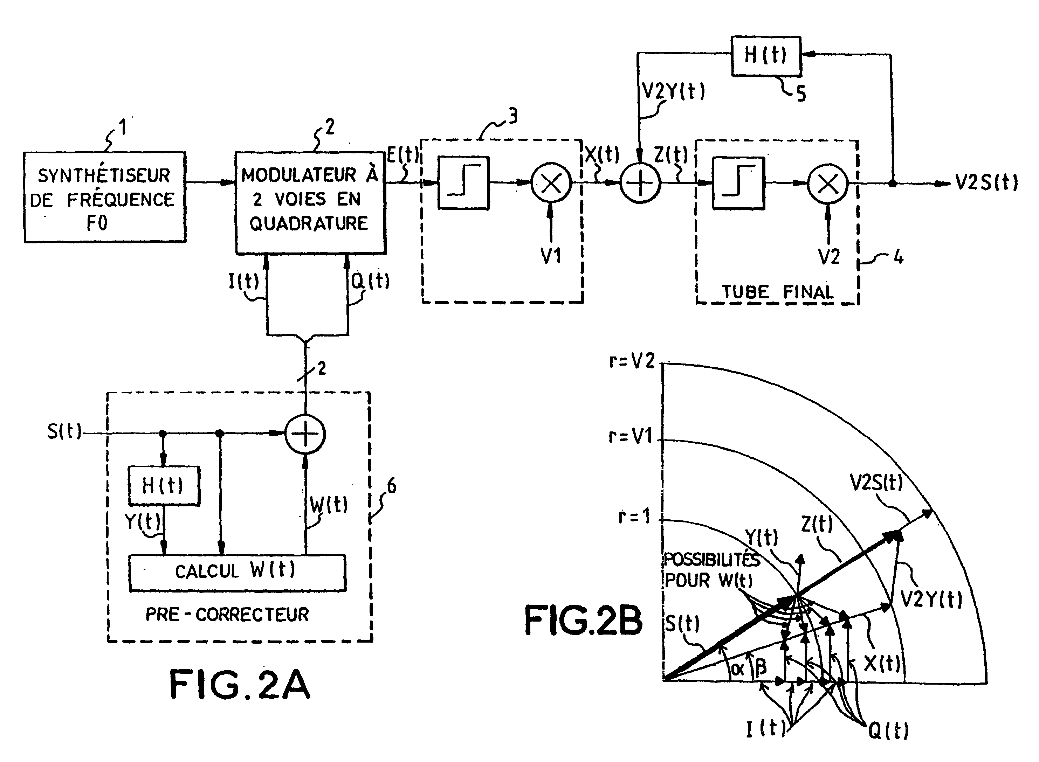

Le tube de sortie 4 est polarisé de manière à travailler en saturation. Il est par conséquent modélisé par un limiteur dur suivi d'un multiplieur de gain fixe $V_2$. Par conséquent, le signal S(t) est représenté avec une amplitude $V_2$ et une phase identique à celle du signal d'entrée du tube Z(t). Pour remédier à la distorsion de phase $\delta$ introduite par la fonction de transfert H(t) du couplage 5, le signal amplifié X(t) est pré-distordu de telle manière que le signal de sortie de l'émetteur S(t) corresponde à un signal désiré à émettre. Les moyens mis en oeuvre pour réaliser cette pré-distorsion sont représentés schématiquement sur la figure 2A. Les signaux correspondant au dispositif de la figure 2A sont représentés sur la figure 2B en considérant leur amplitude relative ainsi que leur phase relative. L'émetteur représenté est équipé de moyens 6 lui permettant de mettre en oeuvre le procédé selon l'invention.

Les moyens 6 consistent en un système de pré-correction comprenant essentiellement un processeur de traitement de signal. Connaissant le couplage 5 de fonction de transfert H(t), le système de pré-correction 6 calcule un signal correcteur W(t) et l'additionne au signal de sortie S(t) désiré de telle sorte que les signaux qu'il génère I(t) et Q(t) vérifient la relation:

$$I(t) + jQ(t) = S(t) + W(t) \qquad (4)$$

Le signal de sortie S(t) désiré est caractérisé par sa phase $\alpha$ donnée dans le plan complexe par rapport aux signaux I(t) et Q(t) en quadrature. Le signal I(t) est choisi pour représenter l'axe réel et Q(t) l'axe imaginaire. Comme le montre la représentation, il existe une infinité de valeurs possibles pour le signal de correction W(t) à laquelle correspond une infinité de valeurs pour les signaux I(t) et Q(t) ; les signaux W(t), I(t) et Q(t) devant vérifier la relation (4).

Le signal S(t) pris comme référence par le système de pré-correction est choisi de façon que son module soit égal à l'unité. Le signal de sortie $V_2$ S(t) a comme amplitude $V_2$ et a la même phase $\alpha$ que le signal S(t). En effet, la pré-distorsion réalisée par le système de pré-correction 6 introduit une rotation de phase de telle manière que le signal amplifié X(t) présente une phase $\beta$ et une amplitude $V_1$. Le couplage 5 de fonction de transfert H(t) a un effet de rotation de phase qui s'oppose à la pré-distorsion introduite par le système de pré-correction 6. La rotation de phase est introduite par l'addition de la fraction $V_2Y(t)$ du signal de sortie $V_2S(t)$ avec le signal amplifié X(t).

Selon un mode préférentiel de réalisation du procédé, le signal de correction W(t) est calculé pour être en quadrature avec le signal S(t). Le signal de correction s'écrit sous la forme :

$$W(t) = j \, g(t) \, S(t) \qquad (5)$$

où g(t) est un gain fonction du temps.

Etant donné les différentes relations qui lient les signaux représentés sur la figure 2B, il vient l'expression de g(t):

$$g(t) = \frac{\frac{V2}{V1}\mathrm{Im}[S(t)\,Y*(t)]}{\sqrt{1 - \frac{V2}{V1}\mathrm{Im}[S(t)\,Y*(t)]^2}} \qquad (6)$$

dans laquelle Im(SIGNAL) représente la partie imaginaire de SIGNAL et SIGNAL* représente le conjugé de SIGNAL.

Suivant l'expression (6), g(t) est nul lorsque la partie imaginaire de $S(t)\,Y*(t)$ est nulle. En effet, cela correspond au cas où Y(t) est colinéaire avec S(t), et par conséquent avec X(t), et par-là même n'introduit pas de distorsion de phase.

Un exemple simple permet d'illustrer le mode préférentiel précédent. Dans cet exemple, le couplage anode-grille est du type résistance-capacité avec une fonction de transfert H(t) représentée par sa transformée de Laplace H(p) :

$$H(p) = \frac{\tau p}{1 + \tau p} \qquad (7)$$

avec $\tau$ une constante de temps faible, entre 10 et 100 ns.

Le système de pré-correction est numérique. Il travaille sur des signaux échantillonnés à une période d'échantillonnage T. L'expression de la fonction de transfert H(t) à prendre en compte est par conséquent H(z), version échantillonnée de H(p).

H(z) est obtenue en remplaçant dans H(p), p par :

$$\frac{2}{T} \frac{1 - z^{-1}}{1 + z^{-1}} \qquad (8).$$

En considérant que la fréquence porteuse est $F_0$ et que $\omega_0 = 2\pi F_0$, il vient :

$$H(z) = G \frac{1 + A z^{-1}}{1 + B z^{-1}} \qquad (9)$$

avec

$$G = \frac{2 + j\omega_0 T}{2 + j\omega_0 T + \frac{T}{\tau}}, \quad A = \frac{j\omega_0 T - 2}{j\omega_0 T + 2}, \quad B = \frac{j\omega_0 T + \frac{T}{\tau} - 2}{j\omega_0 T + \frac{T}{\tau} + 2}.$$

Le $n^{\text{ème}}$ échantillon du signal Y(t), résultat de la convolution de S(t) et de H(t), est calculé avec la formule de récursion suivante :

$$Y(nT) = G\,[S(nt) + AS((n-1)T) - BY((n-1)T)] \qquad (10)$$

Connaissant Y(nT), il est possible de déterminer g(t) à l'instant t=nT en utilisant la relation (6) puis d'en déduire W(t) au même instant en appliquant la relation (5). Enfin, I(t) et Q(t) sont déterminés pour l'instant t=nT en appliquant la relation (4). Soit :

$$I(nT) + jQ(nT) = S(nT)\,(1 + jg(nT)) \qquad (11)$$

Le système peut réaliser une correction plus complexe. Il suffit pour cela de prendre en compte une fonction de transfert H(t) du couplage anode-grille plus élaborée. La fonction de transfert H(p) peut être choisie d'un ordre plus élevé, par exemple deux. La version échantillonnée H(z) de H(p) peut alors s'exprimer sous la forme

$$H(z) = G \; \frac{1 + A_1 z^{-1}}{1 + B_1 z^{-1}} \; \frac{1 + A_2 z^{-1}}{1 + B_2 z^{-1}} \qquad\qquad (12)$$

ou sous la forme :

$$H(z) = G \; \frac{1 + A_1 z^{-1} + 1 + A_2 z^{-1}}{1 + B_1 z^{-1} + 1 + B_2 z^{-1}} \qquad\qquad (13)$$

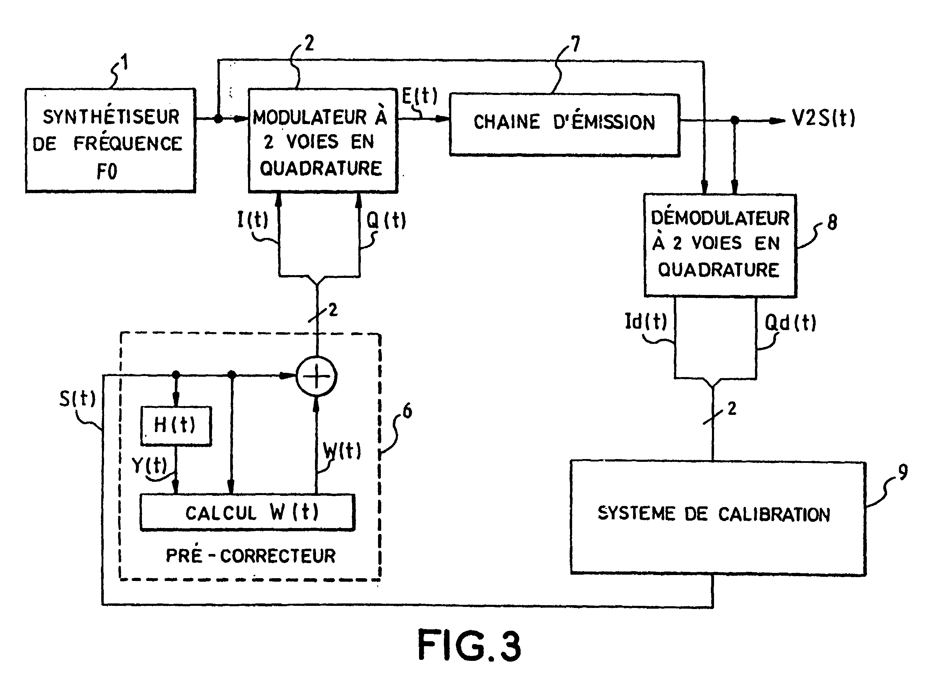

La fonction de transfert H(t) du couplage anode-grille peut être supposée connue comme étant une caractéristique de l'émetteur. Sinon, elle peut être déterminée par un système de calibration associé à un démodulateur. La figure 3 représente un émetteur mettant en oeuvre le procédé selon l'invention et équipé d'un système pour évaluer la fonction de transfert du couplage anode-grille. Par rapport à la précédente représentation figure 2A de l'émetteur, l'amplificateur et le tube final ont été regroupés dans la chaîne d'émission 7. L'entrée E(t) de la chaîne d'émission 7 correspond à l'entrée de l'amplificateur 3 dit « driver » et la sortie $V_2$ S(t) de la chaîne d'émission 7 correspond à la sortie du tube final 4.

Le système d'évaluation de la fonction de transfert du couplage anode-grille comprend un démodulateur 8 à deux voies en quadrature et un système de calibration 9.

Le démodulateur 8 démodule le signal de sortie $V_2 S(t)$ effectivement émis en démodulant au moyen de la fréquence $F_0$ ayant servi à la modulation. Le signal démodulé est représenté par deux signaux en quadrature Id(t) et Qd(t).

Le système de calibration (9) a pour fonction d'ajuster les coefficients G, $A_i$, $B_i$ de la fonction de transfert H(z). Cet ajustement peut être réalisé suivant le déroulement suivant:

- dans une étape initiale, les coefficients G, $A_i$, $B_i$ sont initialisés à zéro,
- dans une deuxième étape, la fréquence d'émission $F_0$ est fixée à une valeur donnée comprise dans le canal d'émission choisi,
- dans une troisième étape, les coefficients G, $A_i$, $B_i$ sont calculés en utilisant la relation (9),
- dans une quatrième étape, les coefficients G, $A_i$, $B_i$ sont modifiés n-1 fois et seules sont gardées ceux qui permettent de minimiser l'écart de phase entre le signal démodulé Id + jQd et le signal espéré S(t).

Par exemple, pour des valeurs $G_0$, $A_0$, $B_0$ déterminées lors de la troisième étape, n-1 autres valeurs sont testées pour chaque coefficient. Soit globalement n $\times$ n $\times$ n = 125 jeux de valeurs dans le cas où n=5 par exemple.

Par exemple, pour G, les valeurs testées peuvent être données par:
$G_0/G_0 + \varepsilon/G_0 - \varepsilon/G_0 + j\varepsilon$ et $G_0 - j\varepsilon$ avec $\varepsilon$ une constante faible. Le déroulement des étapes précédentes peut être repris avec d'autres fréquences du canal considéré jusqu'à ce que l'écart de phase ne puisse plus être réduit.

L'évaluation de la fonction de transfert du couplage anode-grille peut être réalisée lors de la mise en service de l'émetteur, c'est-à-dire une fois pour toutes.

Etant donné le caractère numérique de l'évaluation, il apparaît plus efficace de réaliser cette évaluation régulièrement. Par exemple, après chaque mise sous tension de l'émetteur ou bien avant chaque émission.

**Revendications**

1. Procédé de neutrodynage du tube d'un émetteur de radiodiffusion, de type numérique de forte puissance, comprenant un amplificateur (3) travaillant à saturation avec un gain $V_1$ et amplifiant un signal d'entrée E(t) modulé en phase issu d'un modulateur (2), le modulateur (2) modulant à une fréquence d'émission ($F_0$) deux signaux en quadrature I(t), Q(t) pour commander la grille du tube (4), le tube (4) travaillant à saturation avec un gain $V_2$, le procédé consistant à pré-distordre par des moyens numériques le signal d'entrée E(t) pour compenser le couplage (5) indésirable entre l'anode et la grille du tube (4) de l'émetteur de telle sorte que la sortie de l'émetteur corresponde à un signal de sortie S(t) désiré, **caractérisé en ce qu'**il consiste :

   - à déterminer l'expression de la fonction de transfert H(t) du couplage (5) anode-grille,
   - à calculer un signal correcteur W(t) en quadrature avec le signal de sortie S(t) désiré en calculant l'expression :

$$W(t) = jg(t) \, S(t)$$

avec

$$g(t) = \frac{\dfrac{V2}{V1}\,\mathrm{Im}\left(S(t).\dot{Y}^{*}(t)\right)}{\sqrt{1-\left[\dfrac{V2}{V1}\,\mathrm{Im}\left(S(t).Y^{*}(t)\right)\right]^{2}}}$$

où Im(SIGNAL) est la partie imaginaire de SIGNAL

$Y(t) = S(t){*}H(t)$, avec $*$ le produit de convolution et $Y(t)$ le signal issu du couplage anode-grille et réinjecté sur la grille,

SIGNAL* le conjugué du signal SIGNAL,

- et à déterminer les signaux en quadrature $I(t)$ et $Q(t)$ permettant d'obtenir le signal d'entrée $E(t)$ pré-distordu en appliquant la relation :

$$I(t) + jQ(t) = S(t) + W(t)$$

2. Procédé de neutrodynage selon la revendication 1, **caractérisé en ce qu'**il consiste :

à déterminer régulièrement l'expression de la fonction de transfert $H(t)$ du couplage anode-grillle au moyen d'un système d'évaluation (8, 9) qui mesure un écart de phase entre le signal de sortie ($V_2 S(t)$) démodulé (Id(t), Qd(t)) et le signal espéré $S(t)$ pour ajuster l'expression de la fonction de transfert $H(t)$ de manière à minimiser l'écart de phase précédent.

3. Emetteur de radiodiffusion de type numérique de forte puissance, pour la mise en oeuvre du procédé selon la revendication 1, comprenant, dans une chaîne, un synthétiseur de fréquence (1), un modulateur (2) à deux voies en quadrature, un amplificateur (3) et un tube final (4), **caractérisé en ce que**, il comprend un système de pré-correction (6) pour calculer le signal correcteur $W(t)$ en quadrature avec le signal $S(t)$ désiré, en calculant l'expression $W(t) = j\, g\,(t)\, S(t)$

avec

$$g(t) = \frac{\dfrac{V2}{V1}\,\mathrm{Im}\left(S(t).Y^{*}(t)\right)}{\sqrt{1-\left[\dfrac{V2}{V1}\,\mathrm{Im}\left(S(t).Y^{*}(t)\right)\right]^{2}}}$$

où lm(SIGNAL) est la partie imaginaire de SIGNAL

$Y(t) = S(t){*}H(t)$. avec $*$ le produit de convolution et $Y(t)$ le signal issu du couplage anode-grille et réinjecté sur la grille,

SIGNAL* le conjugué du signal SIGNAL,

et pour générer deux signaux en quadrature $I(t)$ et $Q(t)$, déterminés par la relation $I(t) + jQ(t) = S(t) + W(t)$,

et **en ce que** le modulateur (2) module les signaux en quadrature $I(t)$ et $Q(t)$ pour générer un signal modulé $E(t)$ qui est amplifié par l'amplificateur (3) pour attaquer la grille du tube final (4).

4. Emetteur de radiodiffusion de type numérique de forte puissance selon la revendication 3, **caractérisé en ce qu'**il comprend un système d'évaluation de la fonction de transfert $H(t)$ du couplage anode-grille comprenant, un démodulateur (8) à deux voies en quadrature (Id(t), Qd(t)) dont les signaux de sortie sont obtenus par démodulation par rapport à la fréquence d'émission ($F_0$) du signal de sortie ($V_2\, s(t)$) effectivement émis et comprenant, un système de calibration (9) qui a pour fonction d'ajuster l'évaluation de la fonction de transfert ($H(t)$) en cherchant à minimiser l'écart de phase entre le signal complexe formé par les signaux de sortie du démodulateur et le signal espéré ($S(t)$).

**Patentansprüche**

1. Verfahren für die Neutralisation einer Rundfunksender-Röhre des digitalen Hochleistungstyps, die einen Verstärker (3), der im Sättigungsbetrieb mit einem Verstärkungsfaktor $V_1$ arbeitet und ein von einem Modulator (2) ausgegebenes phasenmoduliertes Eingangssignal E(t) verstärkt, wobei der Modulator (2) mit einer Sendefrequenz ($F_0$) zwei um 90° phasenverschobene Signal I(t), Q(t) moduliert, um das Gitter der Röhre (4) zu steuern, wobei die Röhre (4) im Sättigungsbetrieb mit einem Verstärkungsfaktor ($V_2$) arbeitet, wobei das Verfahren darin besteht, das Eingangssignal E(t) durch digitale Mittel vorzuverzerren, um die unerwünschte Kopplung (5) zwischen der Anode und dem Gitter der Röhre (4) des Senders in der Weise zu kompensieren, daß das Ausgangssignal des Senders einem erwünschten Ausgangssignal S(t) entspricht, **dadurch gekennzeichnet, daß** es darin besteht:

   - den Ausdruck der Übertragungsfunktion H(t) der Anoden-Gitter-Kopplung (5) zu bestimmen,

   - ein Korrektursignal W(t), das zu dem erwünschten Ausgangssignal S(t) um 90° phasenverschoben ist, zu berechnen, indem der Ausdruck:

$$W(t) = j \, g(t) S(t)$$

        mit

$$g(t) = \frac{\dfrac{V_2}{V_1} \mathrm{Im}\big(S(t) \cdot Y*(t)\big)}{\sqrt{1 - \left[\dfrac{V_2}{V_1} \mathrm{Im}\big(S(t) \cdot Y*(t)\big)\right]^2}}$$

        berechnet wird, wobei Im(SIGNAL) der Imaginärteil von SIGNAL ist,
        Y(t) = S(t)*H(t), wobei * das Faltungsprodukt ist und Y(t) das von der Anoden-Gitter-Kopplung stammende Signal ist, das wieder in das Gitter eingegeben wird,
        SIGNAL* die Konjugierte des Signals SIGNAL ist,
        berechnet wird,

   - und die um 90° phasenverschobenen Signale I(t) und Q(t) zu bestimmen, was ermöglicht, das vorverzerrte Eingangssignal E(t) zu erhalten, indem die Beziehung:

$$I(t) + j \, Q(t) = S(t) + W(t)$$

        angewendet wird.

2. Neutralisationsverfahren nach Anspruch 1, **dadurch gekennzeichnet, daß** es darin besteht:

        regelmäßig den Ausdruck der Übertragungsfunktion H(t) der Anoden-Gitter-Kopplung mittels eines Auswertungssystems (8, 9) zu bestimmen, das einen Phasenabstand zwischen dem demodulierten Ausgangssignal ($V_2$ S(t)) (Id(t), Qd(t)) und dem erhofften Signal S(t) mißt, um den Ausdruck der Übertragungsfunktion H(t) in der Weise einzustellen, daß der vorhergehende Phasenabstand minimal wird.

3. Rundfunksender des digitalen Hochleistungstyps für die Ausführung des Verfahrens nach Anspruch 1, der in einer Kette einen Frequenzsynthetisierer (1), einen Modulator (2) mit zwei um 90° phasenverschobenen Wegen, einen Verstärker (3) und eine Endröhre (4) umfaßt, **dadurch gekennzeichnet, daß** er ein Vorkorrektursystem (6) umfaßt, um das Korrektursignal W(t), das zu dem erwünschten Signal S(t) um 90° phasenverschoben ist, zu berechnen, indem der Ausdruck W(t) = j g(t)S(t) berechnet wird,
        wobei

$$g(t) = \frac{\frac{V_2}{V_1} \mathrm{Im}\left(S(t) \cdot Y*(t)\right)}{\sqrt{1 - \left[\frac{V_2}{V_1} \mathrm{Im}\left(S(t) \cdot Y*(t)\right)\right]^2}}$$

wobei Im(SIGNAL) der Imaginärteil von SIGNAL ist,

Y(t) = S(t)*H(t), wobei * das Faltungsprodukt ist und Y(t) das von der Anoden-Gitter-Kopplung stammende Signal ist, das wieder in das Gitter eingegeben wird,

SIGNAL* die Konjugierte des Signals SIGNAL ist,

und zwei um 90° phasenverschobene Signale I(t) und Q(t) erzeugt werden, die durch die Beziehung I(t) + j Q(t) = S(t) + W(t) bestimmt sind,

und daß der Modulator (2) die um 90° phasenverschobenen Signale I(t) und Q(t) moduliert, um ein moduliertes Signal E(t) zu erzeugen, das durch den Verstärker (3) verstärkt wird, um auf das Gitter der Endröhre (4) einzuwirken.

4. Rundfunksender des digitalen Hochleistungstyps nach Anspruch 3, **dadurch gekennzeichnet, daß** er ein System für die Auswertung der Übertragungsfunktion H(t) der Anoden-Gitter-Kopplung umfaßt und versehen ist mit einem Demodulator (8) mit zwei um 90° phasenverschobenen Wegen (Id(t), Qd(t)), dessen Ausgangssignale durch Demodulation in bezug auf die Sendefrequenz ($F_0$) des effektiv gesendeten Ausgangssignals ($V_2$ S(t)) erhalten werden, und versehen ist mit einem Kalibrierungssystem (9), das die Aufgabe hat, die Auswertung der Übertragungsfunktion (H(t)) einzustellen, indem es versucht, den Phasenabstand zwischen dem durch die Ausgangssignale des Demodulators gebildeten komplexen Signal und dem erhofften Signal (S(t)) minimal zu machen.

## Claims

1. Process for neutralizing the tube of a radio broadcasting transmitter, of high power digital type, comprising an amplifier (3) working at saturation with a gain $V_1$ and amplifying a phase-modulated input signal E(t) emanating from a modulator (2), the modulator (2) modulating at a transmission frequency ($F_0$) two quadrature signals I(t), Q(t) so as to control the grid of the tube (4), the tube (4) working at saturation with a gain $V_2$, the process consisting in pre-distorting the input signal E(t) by digital means so as to compensate for the undesirable coupling (5) between the anode and the grid of the tube (4) of the transmitter in such a way that the output of the transmitter corresponds to a desired output signal S(t), **characterized in that** it consists:

   - in determining the expression for the transfer function H(t) of the anode/grid coupling (5),
   - in calculating a corrector signal W(t) in quadrature with the desired output signal S(t) by calculating the expression:

$$W(t) = jg(t)S(t)$$

with

$$g(t) = \frac{\frac{V2}{V1} \mathrm{Im}\left(S(t).Y*(t)\right)}{\sqrt{1 - \left[\frac{V2}{V1} \mathrm{Im}\left(S(t).Y*(t)\right)\right]^2}}$$

where Im(SIGNAL) is the imaginary part of SIGNAL

Y(t) = S(t)*H(t), with * the convolution product and Y(t) the signal arising from the anode/grid coupling and fed back to the grid,

SIGNAL* the conjugate of the signal SIGNAL,

- and in determining the quadrature signals I(t) and Q(t) making it possible to obtain the pre-distorted input signal E(t) by applying the relation:

$$I(t) + jQ(t) = S(t) + W(t)$$

2. Neutralization process according to Claim 1, **characterized in that** it consists:

in regularly determining the expression for the transfer function H(t) of the anode/grid coupling by means of an evaluation system (8, 9) which measures a phase deviation between the output signal ($V_2S(t)$) demodulated (Id(t), Qd(t)) and the expected signal S(t) so as to adjust the expression for the transfer function H(t) in such a way as to minimize the above phase deviation.

3. Radio broadcasting transmitter of high power digital type, for implementing the process according to Claim 1, comprising, in a chain, a frequency synthesizer (1), a modulator (2) having two quadrature pathways, an amplifier (3) and a final tube (4), **characterized in that**, it comprises a pre-correction system (6) for calculating the corrector signal W(t) in quadrature with the desired signal S(t), by calculating the expression w(t)=jg(t)S(t)
with

$$g(t) = \frac{\dfrac{V2}{V1} \, \text{Im}\left(S(t).Y^*(t)\right)}{\sqrt{1 - \left[\dfrac{V2}{V1} \, \text{Im}\left(S(t).Y^*(t)\right)\right]^2}}$$

where Im (SIGNAL) is the imaginary part of SIGNAL

Y(t) = S(t)*H(t), with * the convolution product and Y(t) the signal arising from the anode/grid coupling and fed back to the grid,

SIGNAL* the conjugate of the signal SIGNAL,

and for generating two quadrature signals I(t) and Q(t), determined by the relation I(t) + jQ(t) = S(t) + W(t),

and **in that** the modulator (2) modulates the quadrature signals with I(t) and Q(t) so as to generate a modulated signal E(t) which is amplified by the amplifier (3) so as to drive the grid of the final tube (4).

4. Radio broadcasting transmitter of high power digital type according to Claim 3, **characterized in that** it comprises a system for evaluating the transfer function H(t) of the anode/grid coupling comprising, a demodulator (8) having two quadrature pathways (Id(t), Qd(t)) whose output signals are obtained by demodulation with respect to the transmission frequency ($F_0$) of the output signal ($V_2s(t)$) actually transmitted and comprising, a calibration system (9) whose function is to adjust the evaluation of the transfer function (H(t)) by seeking to minimize the phase deviation between the complex signal formed by the output signals of the demodulator and the expected signal (S(t)).

FIG.1A

FIG.1B

FIG.2A

FIG.2B

FIG.3